# EUROPEAN PATENT APPLICATION

(11) **EP 4 679 123 A1**
(43) Date of publication of application: **14.01.2026**
(21) Application number: 24188171.3
(22) Date of filing: 12.07.2024
(51) Int. Cl.: G01R 33/56, G01R 33/48

(54) **MAGNETIC RESONANCE IMAGING USING CONTRAST MANIPULATION BY MAGNETIZATION PREPARATION**

(71) Applicant: Koninklijke Philips N.V., 5656 AG Eindhoven (NL)
(72) Inventor: PEETERS, Johannes Martinus, Eindhoven (NL); SMINK, Jouke, Eindhoven (NL); KATSUMATA, Yasutomo, 5656AG Eindhoven (NL); KWON, Jihun, Eindhoven (NL); BECK, Gabriele, Eindhoven (NL)
(74) Representative: Philips Intellectual Property & Standards

(57) **Abstract**

The invention discloses a method of imaging an object (10) placed in a magnetic field, comprising: subjecting the object (10) to a contrast preparation sequence (PRE) comprising at least one preparation radiofrequency, RF, pulse to non-selectively or selectively, partially or completely manipulate nuclear magnetization; subjecting the object (10) to an imaging sequence (IM) comprising at least one excitation RF pulse and switched magnetic field gradients to generate magnetic resonance, MR, signals, wherein the imaging sequence (IM) starts directly after the preparation sequence (PRE) and samples a central portion of k-space (C) during a first time interval (TI1) encompassing a target time point at which the nuclear magnetization assumes a desired state after the contrast preparation sequence (PRE), and subsequently samples peripheral portions (PN, PP) of k-space during a second time interval (TI2); acquiring the MR signals from the object (10); and reconstructing an MR image from the acquired MR signals, wherein the visibility of particular tissues, structures, or pathological conditions within the object (10) is enhanced in the MR image by the contrast preparation sequence (PRE). A system is further disclosed, comprising a computational system configured to perform the method.

## Description

### FIELD OF THE INVENTION

The invention relates to the field of magnetic resonance (MR) imaging. It concerns a method of MR imaging of an object placed in a main magnetic field. The invention also relates to an MR system and to a computer program to be run on an MR system.

### BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

A key challenge in MR imaging is the differentiation of tissues by producing a suitable contrast in the final MR image. Contrast preparation sequences are known as pulse sequences and manipulations that are applied to the nuclear magnetization before the actual acquisition of MR signals. The purpose of this preparation is to create a specific state of the nuclear magnetization that enhances the contrast between different tissues or structures in the MR image. These preparation sequences exploit, e.g., the different relaxation properties (T₁, T₂, and T₂*) and other characteristics of tissues to highlight specific features and improve diagnostic accuracy.

One particular issue in MR imaging is distinguishing pathological tissues from surrounding fat, which can obscure critical details or - in general - background tissue. To address this, specialized MR imaging techniques have been developed for fat suppression, among which "Spectral Presaturation with Inversion Recovery" (SPIR) and "Spectral Attenuated Inversion Recovery" (SPAIR) are prominent. Other inversion techniques use one or more inversion radiofrequency (RF) pulses to suppress the background tissue and to enhance the pathological tissue. Other inversion techniques are known for labeling blood in non-contrast enhanced MR imaging. These techniques enhance tissue contrast by selectively suppressing contributions from fat protons or background tissue to the generated and acquired MR signals. SPIR is a technique that combines spectral pre-saturation with the inversion recovery method to suppress fat signals in MR images. It is performed by first applying a spectrally selective inversion radiofrequency (RF) pulse that is specifically tuned to the resonance frequency of fat protons. This RF pulse achieves a selective partial inversion of the nuclear magnetization associated with fat protons without significantly affecting the nuclear magnetization of water protons or other tissues. The spectrally selective inversion RF pulse has a (variable) flip angle determining the extent of magnetization inversion. Following this, a delay time passes allowing the nuclear magnetization of fat protons to recover towards its equilibrium state. By carefully determining the flip angle and the delay time such that the start of the then following imaging sequence coincides with the null point/zero crossing of fat nuclear magnetization, i.e. the moment when the longitudinal nuclear magnetization of fat protons is zero, the MR signal contributions from fat protons are minimized in the resulting MR image. Contributions from other tissues to the MR signal are not selectively inverted and are thus not suppressed in the MR image. Their respective longitudinal nuclear magnetization is in the equilibrium at the time point at which the imaging sequence starts. SPIR is particularly useful in areas where fat and other tissues are closely intermixed, such as in the breast, liver, and musculoskeletal system, providing images that are better suited for diagnostic purposes.

SPAIR is a refinement of the afore described SPIR technique. Similar to SPIR, SPAIR involves applying a spectrally selective RF inversion pulse. However, it is designed to fully invert the magnetization of fat, i.e. the flip angle of the RF inversion pulse is 180°. SPAIR employs an adiabatic inversion RF pulse, which fully inverts the magnetization of fat even when the B₁ (RF) field is spatially nonuniform, making the technique less susceptible to variations in B₁. SPAIR is highly valued in abdominal, pelvic, and orthopedic imaging, where consistent fat suppression across large fields of view is critical for accurate diagnosis.

By selectively targeting the suppression of the MR signal from fat protons while preserving or enhancing the MR signal from other tissues, SPIR and SPAIR greatly aid in the diagnosis and assessment of various medical conditions, from detecting tumors and lesions to evaluating musculoskeletal injuries.

In the context of dynamic contrast-enhanced (DCE) examinations, which involve administering contrast agents to enhance tissue visualization, fat suppression is crucial. It improves the contrast-to-noise ratio (CNR) and delineates the contrast-enhanced structures more clearly. When combined with (volumetric) Turbo Field Echo (TFE) imaging sequences, SPIR and SPAIR techniques achieve a high temporal and spatial resolution with uniform fat suppression across the entire volume. This is particularly important in DCE-MRI, where contrast dynamics need to be observed without interference from fat signal.

SPAIR has the advantage compared to SPIR that it is less sensitive to B₁ (RF) inhomogeneity. However, as the flip angle of the inversion RF pulse is fixed to 180° in SPAIR, there are some limitations to the TFE imaging train applied between successive inversion RF pulses. In particular, dead times (referring to non-productive periods in the imaging cycle) are an issue. The adiabatic inversion RF pulse and the wait time for fat magnetization to reach the null point/zero crossing introduce dead times in SPAIR sequences. Moreover, if the TFE imaging train is too short, the acquisition of MR signals from central k-space will be too late, which must be mitigated by adding dead time at the end of the TFE train. While SPAIR is more effective in providing uniform fat suppression and is less sensitive to B₁ inhomogeneities, the dead times can impact the efficiency of dynamic imaging. SPAIR sequences are generally designed to minimize these dead times, but they still contribute to the overall acquisition duration. While SPAIR offers effective fat suppression, the associated dead times can impact the efficiency and temporal resolution in dynamic studies.

### SUMMARY OF THE INVENTION

From the foregoing it is readily appreciated that there is a need for an improved MR imaging technique using a contrast preparation sequence, like SPIR or SPAIR, for optimal contrast between different tissues or structures in the final MR image.

In accordance with the invention, a method of MR imaging of an object placed in a main magnetic field B₀ is disclosed. The method of the invention comprises the steps of:
- subjecting the object to a contrast preparation sequence comprising at least one preparation RF pulse to non-selectively or selectively, partially or completely manipulate nuclear magnetization;
- subjecting the object to an imaging sequence comprising at least one excitation RF pulse and switched magnetic field gradients to generate MR signals, wherein the imaging sequence starts directly after the preparation sequence and samples a central portion of k-space during a first time interval encompassing a target time point at which the nuclear magnetization assumes a desired state after the contrast preparation sequence, and subsequently samples peripheral portions of k-space during a second time interval;
- acquiring the MR signals from the object; and
- reconstructing an MR image from the acquired MR signals, wherein the visibility of particular tissues, structures, or pathological conditions within the object is enhanced in the MR image by the contrast preparation sequence. The object as referred to in the disclosure of the invention may be a portion of the body of a subject, e.g., a patient.

The method of the invention employs a contrast preparation sequence executed prior to the actual imaging sequence to non-selectively or selectively, partially or completely manipulate nuclear magnetization in order to generate a desired contrast. The imaging sequence samples a central k-space portion (including the k-space origin) during the first time interval immediately after executing the contrast preparation sequence. This first time interval includes the target time point at which the nuclear magnetization assumes a state to optimally deliver the desired contrast. The first time interval may be arranged essentially symmetrically around the target time point. By sampling the central k-space portion during the first time interval while the nuclear magnetization assumes the desired state it is achieved that the MR signals from the central k-space portion dominating the image contrast are acquired when the nuclear magnetization assumes the state that delivers the desired contrast.

Ideally, the sampling of the actual k-space center (k=0) temporally coincides with the target time point. As the first time interval starts directly after executing the contrast preparation sequence, no delay time is provided that conventionally allows the nuclear magnetization to approach the desired state before the MR signal acquisition is started. Instead, the sampling during the first time interval starts immediately after the inversion RF pulse according to the invention within the central portion of k-space but at a position outside the actual k-space center (k=0), reaching the k-space center at the target time point, and then progressing further within the central portion of k-space until the end of the first time interval. The peripheral portions of k-space are sampled thereafter during the second time interval. As a result of this, the contrast-to-noise ratio (e.g., the level of background tissue suppression) in the reconstructed MR image is good even if the nuclear magnetization has already partially recovered to assume its equilibrium state when the peripheral k-space portions are sampled.

In other words, the invention achieves to reduce the dead times of the contrast-prepared image acquisition in that during the (partial) recovery of the nuclear magnetization the peripheral portions of k-space are sampled that are less sensitive to contamination with contributions from the recovering nuclear magnetization.

Next to a faster acquisition and a correspondingly higher temporal resolution, the approach of the invention is also beneficial as a steady state of the nuclear magnetization can be achieved easier and faster.

In a possible embodiment, the target time point is automatically calculated from the sequence parameters of the contrast preparation and imaging sequences (flip angles, shot lengths, echo times etc.) and/or the nuclear relaxation times of the involved tissues in the object, so as to set the contrast-to-noise ratio in the reconstructed MR image as desired (e.g., to obtain an optimal contrast-to-noise ratio).

In a further possible embodiment, the contrast preparation sequence comprises one or more inversion RF pulses to invert nuclear magnetization at least partially, depending on the flip angle. The contrast preparation sequence may comprise a spectrally selective inversion RF pulse to selectively invert nuclear magnetization associated with fat protons within the object so that the desired contrast is achieved by suppressing contributions from fat protons in the reconstructed MR image. In another variant, the contrast preparation sequence may use a flow labeling inversion RF pulse.

To obtain an optimal contrast in these cases, the target time point may be the instant of zero crossing of the nuclear magnetization undergoing longitudinal relaxation after inversion. In another possible embodiment, the preparation sequence uses an adiabatic inversion RF pulse. This insofar corresponds to the known SPAIR technique. The adiabatic inversion RF pulse is designed to fully invert the magnetization of fat. The flip angle of the RF inversion pulse is thus fixed at 180°.

The k-space sampling patterns for sampling the central and peripheral portions of k-space can be freely chosen as desired, in principle. In a possible embodiment, the imaging sequence samples the central portion of k-space with linear progression in a phase-encoding direction during the first time interval. Thereafter, the peripheral portions on both (positive and negative) sides of the central k-space portion are sampled in an alternating fashion during the second time interval. MR signals are thus acquired during the second time interval from the peripheral k-space portions along opposite directions in the phase encoding direction.

In another embodiment, the successive steps of subjecting the object to the contrast preparation sequence and subjecting the object to the imaging sequence are repeated cyclically to reconstruct a dynamic series of MR images from the acquired MR signals. To achieve the highest possible temporal resolution and the shortest possible acquisition time, the first and second time intervals together fill the period between two consecutive contrast preparation sequences essentially without dead times.

In yet another embodiment, the imaging sequence is a gradient echo sequence, in particular a fast field echo sequence ("Turbo Field Echo", TFE and its variants), or a spin echo sequence, in particular a fast spin echo sequence ("Turbo Spin Echo", TSE and its variants). As explained above, TFE imaging sequences are very well suited to be combined with SPIR and SPAIR techniques to achieve a high temporal and spatial resolution with uniform fat suppression. This is particularly advantageous in DCE-MRI to monitor the arrival of the contrast agent by T₁ weighted gradient echo imaging.

The imaging sequence may be a 2D sequence.
However, in a possible embodiment, the imaging sequence is a 3D sequence sampling volumetric central and peripheral k-space portions. In a possible variant, the imaging sequence samples k-space according to a stack of stars or stack of spiral scheme in which k-space is sampled radially or spirally from a number of parallel planes in k-space with the phase-encoding direction being oriented perpendicular to these planes. The known stack of stars acquisition technique samples k-space radially from parallel planes, providing high spatial resolution in all three dimensions. The radial sampling approach captures more data points in k-space per unit time, enhancing the detail and sharpness of the resulting MR images. The radial sampling results in an oversampling of the central region of each plane which reduces the level of different types of image artefacts. The enhanced image quality and diagnostic accuracy afforded by this embodiment contribute to accurately follow contrast arrival for angiography or oncologic assessment.

In another possible variant, the imaging sequence samples k-space from an elliptically shaped central k-space portion and peripheral k-space portions during the first and second time intervals respectively, wherein the central k-space portion is acquired in a spiral out in, spiral in out, random or linear fashion, and the peripheral k-space portion in a spiral out fashion.

The method of the invention described thus far can be carried out by means of an MR system including at least one main magnet coil for generating a substantially uniform, steady magnetic field B₀ within an examination volume, a number of gradient coils for generating switched magnetic field gradients in different spatial directions within the examination volume, at least one body RF coil for generating RF pulses within the examination volume and/or for receiving MR signals from a body of a patient positioned in the examination volume, a control unit for controlling the temporal succession of RF pulses and switched magnetic field gradients, and a reconstruction unit for reconstructing MR images from the received MR signals. The method of the invention can be implemented by a corresponding programming of the reconstruction unit and/or the control unit of the MR system.

The method of the invention can be advantageously carried out in most MR systems in clinical use at present. To this end it is merely necessary to utilize a computer program by which the MR system is controlled such that it performs the above-explained method steps of the invention. The computer program may be present either on a data carrier or be present in a data network so as to be downloaded for installation in the control unit of the MR system. The processing of the acquired MR signals for the reconstruction of MR images may also be performed on a computer which is separate from the MR system used for acquisition of the MR signals.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows a block diagram of an MR system for carrying out the method of the invention;
Figs 2A, 2B schematically illustrate the method of the invention as sequence diagrams;
Fig. 3 schematically illustrates the combination of the method of the invention with a volumetric stack of stars acquisition.

### DETAILED DESCRIPTION OF THE EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a computer implemented method and/or in a computer program product, in a corresponding manner.

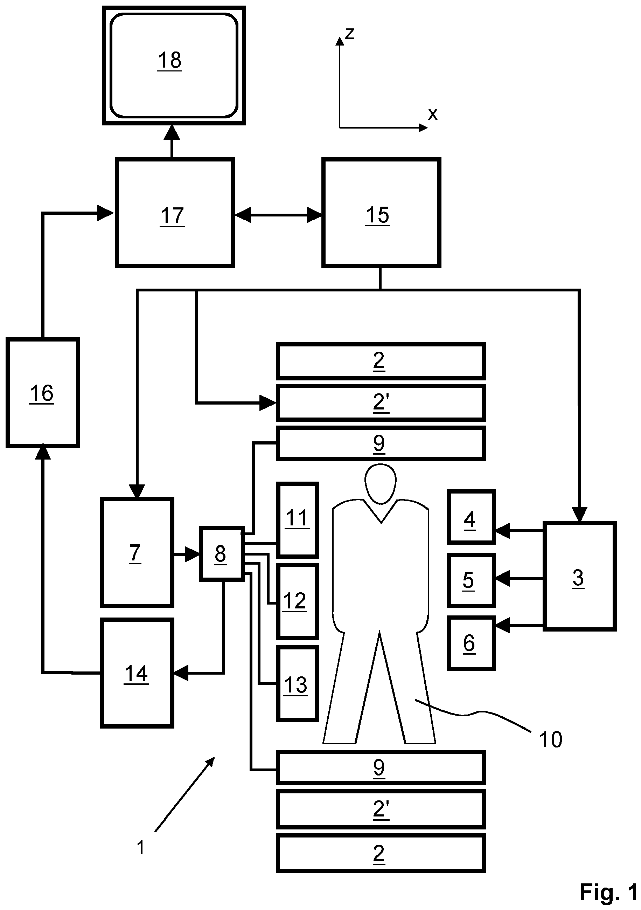

With reference to Fig. 1, an MR system 1 is shown as a block diagram. The device comprises superconducting or resistive main magnet coils 2 such that a substantially uniform, temporally constant main magnetic field B₀ is created along a z-axis through an examination volume. The device further comprises a set of (1^{st}, 2^{nd}, and - where applicable - 3^{rd} order) shimming coils 2', wherein the current flow through the individual shimming coils of the set 2' is controllable for the purpose of minimizing B₀ deviations within the examination volume.

A magnetic resonance generation and manipulation system applies a series of RF pulses and switched magnetic field gradients to invert, excite, saturate, refocus, and spatially and otherwise encode the magnetic resonance to perform MR imaging. More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send/receive switch 8, to a body RF coil 9 to transmit RF pulses into the examination volume. A typical MR imaging sequence is composed of a packet of RF pulse segments of short duration which, together with any applied magnetic field gradients, achieve a selected manipulation of nuclear magnetic resonance. In particular, the RF pulses select a portion of a body 10 positioned in the examination volume. The MR signals are also picked up by the body RF coil 9.

For generation of MR images of limited regions of the body 10, a set of local array RF coils 11, 12, 13 are placed contiguous to the region selected for imaging. The array coils 11, 12, 13 can be used to receive MR signals induced by transmissions of the body RF coil. The resultant MR signals are picked up by the body RF coil 9 and/or by the array RF coils 11, 12, 13 and are demodulated by a receiver 14 preferably including a preamplifier (not shown). The receiver 14 is connected to the RF coils 9, 11, 12 and 13 via the send/receive switch 8. A host computer 15 controls the shimming coils 2' as well as the gradient pulse amplifier 3 and the transmitter 7 to generate the preparation and imaging sequences of the invention. For the selected sequence, the receiver 14 receives signal data from a single or a plurality of k-space lines in rapid succession following each RF excitation pulse. A data acquisition system 16 performs analog-to-digital conversion of the received signals and converts each k-space line to a digital format suitable for further processing. In modern MR systems the data acquisition system 16 is a separate computer which is specialized in acquisition of raw image data.

Ultimately, the digital raw image data are reconstructed into an image representation by a reconstruction processor 17 which applies a Fourier transform or other appropriate reconstruction algorithms, such as SENSE. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor or display screen 18 which provides a man-readable display of the resultant MR image.

The host computer 15 and the reconstruction processor 17 are configured, by corresponding programming, to perform the method of the invention described herein above and in the following.

The functions of the host computer 15, data acquisition system 16 and the reconstruction processor 17 may be performed by one and a same computer comprising at least one processor, or they may be performed by separate computers having their own processor(s). The computer or computers may be termed computational system.

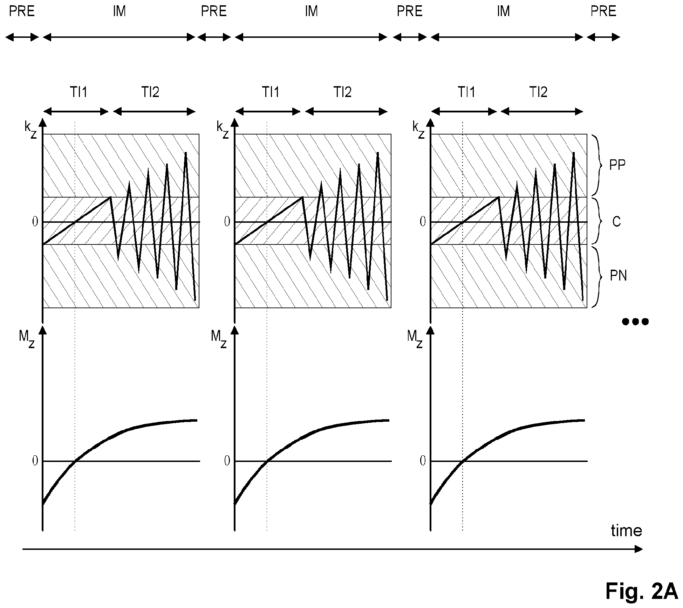

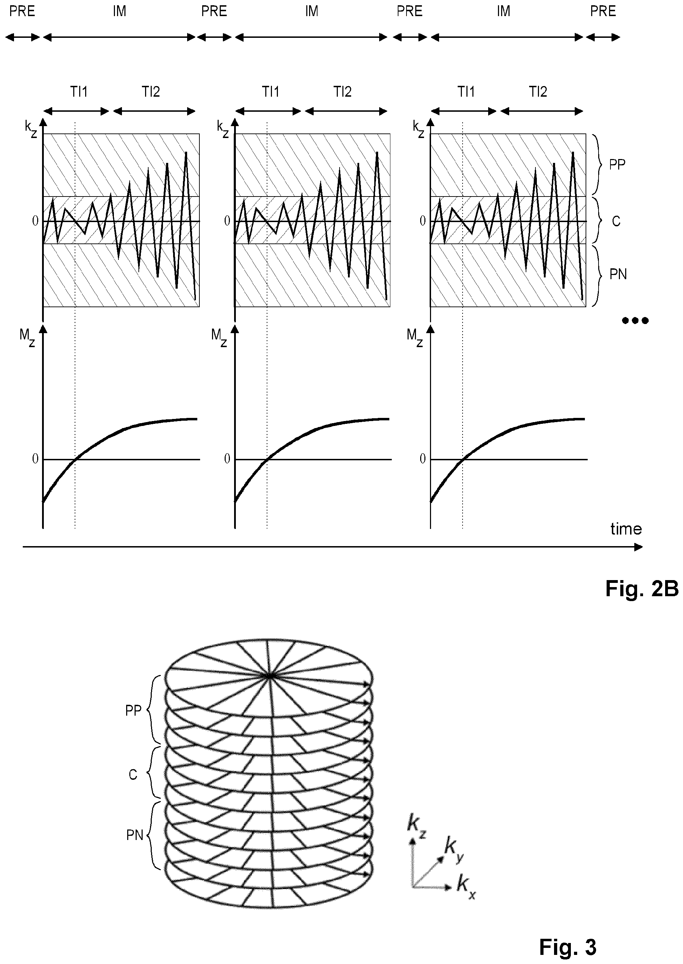

With continuing reference to Fig. 1 and with further reference to Figs 2A, 2B and 3, embodiments of the method of the invention are explained.

The diagram in Figs 2A and 2B illustrates the imaging technique according to the invention. The method starts with subjecting the object 10 to a contrast preparation sequence. The time interval during which the contrast preparation sequence is applied is designated by PRE. The contrast preparation sequence PRE comprises a spectrally selective adiabatic inversion RF pulse (not depicted) to selectively invert nuclear magnetization associated with fat protons within the object 10.

The lower diagrams in Figs 2A and 2B illustrate the temporal evolution of the longitudinal nuclear magnetization M_{z} of fat protons after each of the contrast preparation sequences PRE. It can be seen that the magnetization is inverted, M_{z} is negative after each contrast preparation sequence PRE. Thereafter, the magnetization M_{z} recovers towards equilibrium as a function of time.

Following each contrast preparation sequence PRE, the object 10 is subjected to an imaging sequence, preferably a TFE sequence. The time intervals during which the imaging sequence is executed are designated as IM in Fig. 2. As illustrated in the upper diagrams in Fig. 2A, the imaging sequence IM samples a central k-space portion C (including the k-space origin at k_{z}=0) with a linear progression in the phase-encoding direction k_{z} during a first time interval TI1. In the variant shown in Fig. 2B, the central k-space portion C is sampled in an alternating fashion, i.e. with alternating positive and negative phase-encoding polarities and also varying phase-encoding increments. Alternative k-space sampling patterns are conceivable and are contemplated. After the first time interval TI1, peripheral portions PN, PP on both (negative and positive) sides of the central k-space portion C are sampled in an alternating fashion during a second time interval TI2. Thus, in the second time interval TI2, first an MR signal, i.e. a k-space profile (or a set of k-space profiles) from the negative peripheral k-space portion PN, then a k-space profile (or a set of k-space profiles) from the positive peripheral k-space portion PP, then again a k-space profile (or a set of k-space profiles) from the negative peripheral k-space portion, and so forth, are acquired. In this way, the sampling in the second time interval TI2 zigzags back and forth between the negative and positive peripheral k-space portions, as shown in the upper diagrams in Figs 2A, 2B.

As can further be seen in Figs 2A, 2B, the first time interval TI1 encompasses the instance of zero crossing of the nuclear magnetization M_{z} associated with fat protons undergoing longitudinal relaxation after the selective inversion. This instance, which is the target time point within the meaning of the invention, is indicated by the dashed vertical lines. The target time point is automatically calculated from the sequence parameters of the contrast preparation (PRE) and imaging sequences (IM) and the longitudinal nuclear relaxation time T₁ of the involved tissues in the object (10). The imaging sequence (IM) is set up automatically so that the first time interval TI1 is arranged essentially symmetrically around the instant of zero crossing. Each first time interval TI1 starts directly after the preparation sequence PRE. This means, that no dead time is present before the first time interval TI1. In order to achieve a sufficient fat suppression, the sampling of the actual k-space center (k_{z}=0) temporally coincides with the instant of zero crossing of the nuclear magnetization M_{z} associated with fat protons, as can be seen in both Figs 2A and 2B. The sampling of the central k-space portion C thus starts during the first time interval TI1 outside the actual k-space center (k_{z}=0), then approaches the k-space center at the target time point and then progresses to further sample the central k-space portion C outside the actual k-space center.

As further shown in Figs 2A, 2B, the successive steps of subjecting the object to the contrast preparation sequence PRE and subjecting the object to the imaging sequence IM are repeated cyclically to reconstruct a dynamic series of MR images from the acquired MR signals. Not only three (as depicted) but any higher number of cycles may be applied as required. This is indicated by the three dots to the right in Figs 2A, 2B.

To achieve the highest possible temporal resolution and the shortest possible acquisition time, the first and second time intervals TI1 and TI2 together completely fill the period between two consecutive preparation sequences PRE without dead times.

A dynamic series of MR images is reconstructed from the thus acquired MR signals, wherein contributions from fat protons are suppressed due to the selective inversion by the contrast preparation sequence PRE.

To set up the acquisition scheme of the invention depicted in Figs 2A, 2B, the following workflow may be applied:
1. determine the number of k-space profiles to be acquired by each repetition ("shot") of the TFE imaging sequence IM;
2. from the number of k-space profiles per TFE shot and the duration of the (SPAIR) preparation sequence PRE, the shortest repetition time (time between two successive preparation sequences PRE) is calculated;
3. based on the thus calculated repetition time, the optimal inversion time, i.e. the time required after each contrast preparation sequence PRE until the target time point, i.e. the zero crossing of the nuclear magnetization of fat protons (the tissue that needs to be suppressed) is automatically calculated;
4. the duration of the first time interval TI1 is determined such that the first time interval TI1 is symmetrically arranged around the instance of zero crossing of the nuclear magnetization of fat protons. This means that the same number of k-space profiles is acquired before and after the instant of zero crossing with a linear (Fig. 2A) or alternating (Fig. 2B) progression in the phase-encoding direction k_{z};
5. the remainder of each TFE shot constitutes the second time interval TI2 during which the described alternating sampling of the positive and negative peripheral k-space portions PP, PN is performed.

In the embodiment shown in Fig. 3, the imaging sequence is a 3D sequence sampling volumetric central and peripheral k-space portions C, PN, PP. The imaging sequence samples k-space according to a stack of stars scheme in which k-space is sampled radially from a number (eleven in the depicted embodiment, though other numbers are also contemplated) of parallel planes in k-space. The planes are oriented parallel to the kₓ/k_{y}-directions. The phase-encoding direction k_{z} is oriented perpendicular to the planes. The stack of stars acquisition technique samples k-space radially (with k-space profiles oriented along the radial "spokes" depicted for each plane in Fig. 3) from the parallel planes, providing high spatial resolution in all three dimensions. The planes in the central k-space portion C are sampled in the first time interval TI1 with a linear progression in the phase encoding direction k_{z} while the planes in peripheral k-space portions PN, PP are sampled thereafter in the above-described alternating fashion in the second time interval TI2.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

## Claims

1. A method of imaging an object (10) placed in a magnetic field, comprising:
subjecting the object (10) to a contrast preparation sequence (PRE) comprising at least one preparation radiofrequency, RF, pulse to non-selectively or selectively, partially or completely manipulate nuclear magnetization;
subjecting the object (10) to an imaging sequence (IM) comprising at least one excitation RF pulse and switched magnetic field gradients to generate magnetic resonance, MR, signals, wherein the imaging sequence (IM) starts directly after the preparation sequence (PRE) and samples a central portion of k-space (C) during a first time interval (TI1) encompassing a target time point at which the nuclear magnetization assumes a desired state after the contrast preparation sequence (PRE), and subsequently samples peripheral portions (PN, PP) of k-space during a second time interval (TI2);
acquiring the MR signals from the object (10); and
reconstructing an MR image from the acquired MR signals, wherein the visibility of particular tissues, structures, or pathological conditions within the object (10) is enhanced in the MR image by the contrast preparation sequence (PRE).

2. The method of claim 1, wherein the target time point is automatically calculated from the sequence parameters of the contrast preparation (PRE) and imaging sequences (IM) and/or the nuclear relaxation times of the involved tissues in the object (10), so as to set the contrast-to-noise ratio in the reconstructed MR image.

3. The method of claim 1 or 2, wherein the contrast preparation sequence (PRE) comprises one or more inversion RF pulses to invert nuclear magnetization.

4. The method of claim 3, wherein the contrast preparation sequence (PRE) comprises a spectrally selective inversion RF pulse to selectively invert nuclear magnetization associated with fat protons within the object (10) so that contributions from fat protons are suppressed in the reconstructed MR image.

5. The method of claim 3 or 4, wherein the target time point is the instant of zero crossing of the nuclear magnetization undergoing longitudinal relaxation after the inversion.

6. The method of any one of claims 1 to 5, wherein the first time interval (TI1) is arranged symmetrically around the target time point.

7. The method of any one of claims 1 to 6, wherein the sampling of the k-space center temporally coincides with the target time point.

8. The method of any one of claims 1 to 7, wherein the imaging sequence (IM) samples the central portion of k-space (C) with linear progression in a phase-encoding direction during a first time interval (TI1).

9. The method of any one of claims 1 to 8, wherein the imaging sequence (IM) samples peripheral portions (PN, PP) of k-space during a second time interval (TI2), and wherein the sampling of the peripheral portions (PN, PP) alternates between positive and negative peripheral k-space portions (PN, PP) in the phase-encoding direction.

10. The method of any one of claims 1 to 9, wherein the successive steps of subjecting the object (10) to the preparation sequence (PRE) and subjecting the object (10) to the imaging sequence (IM) are repeated cyclically to reconstruct a dynamic series of MR images from the acquired MR signals, wherein the first and second time intervals (TI1, TI2) together fill the period between two consecutive preparation sequences (PRE) essentially without dead times.

11. The method of any one of claims 1 to 10, wherein the imaging sequence (IM) is a gradient echo sequence, in particular a fast field echo sequence, or a spin echo sequence, in particular a fast spin echo sequence.

12. The method of any one claims 1 to 11, wherein the imaging sequence (IM) is a 3D sequence sampling volumetric central and peripheral k-space portions (C, PN, PP).

13. The method of claim 12, wherein the imaging sequence (IM) samples k-space according to a stack of stars or stack of spirals scheme in which k-space is sampled radially or spirally from a number of parallel planes in k-space with the phase-encoding direction being oriented perpendicular to these planes.

14. An imaging system comprising at least one processor configured to perform a method according to any of the claims 1 to 13.

15. A computer program comprising machine executable instructions, wherein execution of the machine executable instructions causes a computational system to perform a method according to any of the claims 1 to 13.
